# EUROPÄISCHE PATENTSCHRIFT

(11) **EP 1 422 193 B1**
(45) Veröffentlichungstag und Bekanntmachung des Hinweises auf die Patenterteilung: **18.04.2007**
(21) Anmeldenummer: 02079900.3
(22) Anmeldetag: 25.11.2002
(51) Int. Cl.: B81C 1/00

(54) **Verfahren zur Herstellung eines Werkzeugeinsatzes zum spritzgiessen eines teils mit einstufigen Mikrostrukturen**
Process to fabricate a Tool Insert for Injection Moulding a Piece with one-level microstructures
Procéde de fabrication d'un moule pour le coulage par injection d'une pièce avec microstructures à deux niveaux

(43) Veröffentlichungstag der Anmeldung: 26.05.2004
(73) Patentinhaber: Weidmann Plastics Technology AG, 8640 Rapperswil (CH)
(72) Erfinder: Gmür, Max, 9607 Mosnang (CH)
(74) Vertreter: Ventocilla, Abraham

(56) Entgegenhaltungen:
- US-A1- 2002 098 611
- OLSSON A ET AL: "Valve-less diffuser micropumps fabricated using thermoplastic replication" MICRO ELECTRO MECHANICAL SYSTEMS, 1997. MEMS ' 97, PROCEEDINGS, IEEE., TENTH ANNUAL INTERNATIONAL WORKSHOP ON NAGOYA, JAPAN 26-30 JAN. 1997, NEW YORK, NY, USA,IEEE, US, 26. Januar 1997 (1997-01-26), Seiten 305-310, XP010216923 ISBN: 0-7803-3744-1

## Beschreibung

Die Erfindung betrifft ein Verfahren zur Herstellung eines Werkzeugeinsatzes zum Spritzgiessen eines mikrostrukturierten Teils, welches aus einem Kunststoff, einem Metall oder aus einem keramischen Material hergestellt wird und welches eine Anordnung von Mikrostrukturen aufweist, die auf einer Aussenfläche des Teils gebildet werden und eine vorbestimmte Tiefe haben.

Die U.S.-Patentanmeldung US-A-2002/0098611 beschreibt ein Verfahren zur Herstellung integrierter, passiver Komponenten für HF-Nachrichtenübertragung. Hierzu wird die Vorderseite eines Siliziumwafers maskiert und mittels Plasmaätzen Strukturen im Siliziumwafer gebildet. Die Maskierung wird entfernt und elektrochemisch eine Metallschicht auf die Vorderseite des Siliziumwafers und in die darin vorhandenen Strukturen abgeschieden. Die Metallschicht wird planarisiert und vom Siliziumwafer getrennt.

Die Erfindung betrifft ausserdem ein Verfahren zum Spritzgiessen eines Teils, welches aus einem Kunststoff, einem Metall oder aus einem keramischen Material hergestellt wird und welches eine Anordnung von Mikrostrukturen aufweist, die auf einer Aussenfläche des Teils gebildet werden und eine vorbestimmte Tiefe haben, wobei ein Werkzeug zum Spritzgiessen verwendet wird, der von einer ersten und einer zweiten Werkzeughälfte gebildet wird.

Die Internationale Patentanmeldung WO-A-99/29494 beschreibt ein Verfahren zur Herstellung von Linsen mit Mikrostrukturen bestehend aus Kunststoff. Die Linsen werden mittels Spritzguss hergestellt, wobei die genannten Mikrostrukturen durch einen im Spritzgusswerkzeug enthaltenen Werkzeugeinsatz oder durch Mikrostrukturen in einer Werkzeughälfte gebildet werden.

In EP-A-0353748 ist ein Verfahren zur Herstellung eines Hologramms offenbart. Hierzu wird ein gezahnter Werkzeugeinsatz aus Metall hergestellt, welcher in ein Spritzgusswerkzeug eingelegt, und das Hologramm dann unter Verwendung von Polymethymethacrylat spritzgegossen wird.

WO-A-9313933 offenbart ebenfalls ein Verfahren zur Herstellung eines Hologramms mittels Spritzguss. Zuerst wird ein Werkzeugeinsatz, bestehend aus einer einseitig mit Silber beschichteten Metallplatte, hergestellt, wobei die Silberschicht das Negativbild des als Hologramm darzustellenden Bildes bildet. Der Einsatz wird in das Werkzeug eingelegt und das Hologramm mittels Polykarbonatharz spritzgegossen.

Der Artikel 'Valve-Less Diffuser Micropumps Fabricated Using Thermoplastic Replication' von Olsson et al. (Micro electro Mechanical Systems, 1997. MEMS' 97, Proceedings, IEEE., Tenth Annual International Workshop On Nagoya, Japan 26-30 Jan. 1997, New York, NY, USA, IEEE, US, XP010216923 ISBN: 0-7803-3744-1) offenbart ein Verfahren zur Herstellung einer Mikropumpe. Dazu werden mittels Trockenätzen in einem Plasma (DRIE=Deep Reactive Ion Etching) die Strukturen der Mikropumpe in einen Siliziumwafer geätzt. Die geätzte Struktur wird mit Nickel beschichtet und die Nickelbeschichtung als Werkzeugeinsatz in ein Spritzgusswerkzeug zum Spritzgiessen der Mikropumpe mit Polykarbonat eingelegt.

Damit durch Spritzgiessen erzeugte Teile nach dem Spritzgiessen aus dem Werkzeug entformt werden können, ohne dass die Qualität der Mikrostrukturen beeinträchtigt wird, und dass bei grosser Anzahl Mikrostrukturen die Entformungskräfte nicht zu gross werden, müssen die Mikrostrukturen mit Entformungsschrägen versehen werden, welche z.B. grösser als 2 Grad sind, wobei dieser Winkel im Querschnitt zwischen einer Seitenwand der Mikrostruktur und einer zur Aussenfläche des Teils und zur Querschnittsebene senkrechten Ebene gemessen wird.

Es sind folgende Verfahren bekannt, welche die Herstellung von Teilen mit 1-stufigen Mikrostrukturen ermöglichen:
(A) Nassätzen von Glas
(B) Trockenätzen von Silizium
(C) LIGA
(D) UV-LIGA
(E) Laser Machining
(F) Mikroerosion
(G) Mikrozerspannung (Bohren, Fressen, Drehen)

Aller diese bekannten Mikrostrukturierungsverfahren haben jedoch folgende Nachteile:
Mit dem Verfahren (A) lässt sich nur eine eingeschränkte maximale Strukturtiefe erzielen. Das Verfahren (B) ist schwer beherrschbar. Das Verfahren (C) ist sehr aufwendig und teuer. Mit dem Verfahren (D) lässt sich keine oder nur mit sehr viel Aufwand erzeugte Entformungsschräge erzielen. Die Verfahren (E), (F), (G) sind für eine industrielle Anwendung noch zuwenig entwickelt und sind zudem nur sequentiell durchführbar.

Der Erfindung liegt daher die erste Aufgabe zugrunde ein Verfahren zur Herstellung eines mikrostrukturierten Werkzeugeinsatzes der oben erwähnten Art zur Verfügung zu stellen, das bei 1-stufugen Mikrostrukturen die Erzeugung von Entformungsschrägen mit relativ geringem Aufwand ermöglicht.

Gemäss einem ersten Aspekt der Erfindung wird diese erste Aufgabe mit einem Verfahren gemäss Anspruch 1 oder 2 gelöst. Bevorzugte Ausführungsformen sind durch Unteransprüche definiert.

Der Erfindung liegt ferner die zweite Aufgabe zugrunde ein Verfahren zum Spritzgiessen eines Teils zur Verfügung zu stellen, das eine Anordnung von Mikrostrukturen aufweist, die auf einer Aussenfläche des Teils gebildet werden, eine vorbestimmte Tiefe haben und Entformungsschrägen aufweisen, wobei ein Werkzeug zum Spritzgiessen verwendet wird, das von einer ersten und einer zweiten Werkzeughälfte gebildet wird.

Gemäss einem zweiten Aspekt der Erfindung wird diese zweite Aufgabe mit einem Verfahren gemäss Anspruch 7 gelöst.

Die mit den erfindungsgemässen Verfahren erzielten Vorteile sind insbesondere wie folgt:

Das erfindungsgemässe Verfahren ermöglicht auf einfache Weise und mit niedrigen Kosten Entformungsschrägen zu erzeugen, die z.B. grösser als 2 Grad sind. Ein wichtiger Vorteil solcher Entformungsschrägen ist, dass sie die Entformung des Teils ohne Beeinträchtigung der Qualität der Mikrostrukturen und mit geringen Entformungskräften ermöglichen, auch wenn der Wafer viele Mikrostrukturen aufweist.

Das erfindungsgemässe Verfahren hat den zusätzlichen Vorteil, dass die Ätztiefenuniformität durch die Waferdicke gegeben und dadurch hervorragend ist, was sonst beim Silizium Trockenätzen insbesondere wenn die Öffnungen unterschiedliche breit sind, nicht der Fall ist.

Die Erfindung wird nachfolgend anhand eines in den beiliegenden Zeichnungen dargestellter Ausführungsbeispiels näher erläutert. In den beiliegenden Zeichnungen zeigen
Fig. 1 die Mikrostrukturierung der Vorderseite eines ersten Wafers durch durchätzen (Throughetching) Plasmaätzen zur Bildung einer Anordnung von Mikrostrukturen.
Fig. 2 das Bonden der Vorderseite des ersten Wafers auf ein Trägersubstrat zur Bildung eines Galvano-Masters,
Fig. 3 das elektrochemisches Abscheiden einer Metallschicht auf der Vorderseite des ersten Wafers und in den darin vorhandenen durch die durchgehenden Mikrostrukturen gebildeten Hohlräumen,
Fig. 4 die vom ersten Wafer und dem damit gebondeten Trägersubstrat abgetrennte Metallschicht,
Fig. 5 die Verwendung einer vom ersten Wafer und vom damit gebondeten Trägersubstrat abgetrennten Metallschicht als formgebendes Teil eines erfindungsgemäss hergestellten Werkzeugeinsatzes, der in eine Werkzeughälfte eingebaut ist, welche zu einem Werkzeug zum Spritzgiessen eines Teils gehört. Fig. 5 zeigt ausserdem eine in den Innenraum des Spritzgusswerkzeuges eingespritzte Materialschmelze.
Fig. 6 die Entformung eines Teils von der soeben erwähnten Metallschicht,
Fig. 7 das aus dem Spritzgusswerkzeug entformten Teil.

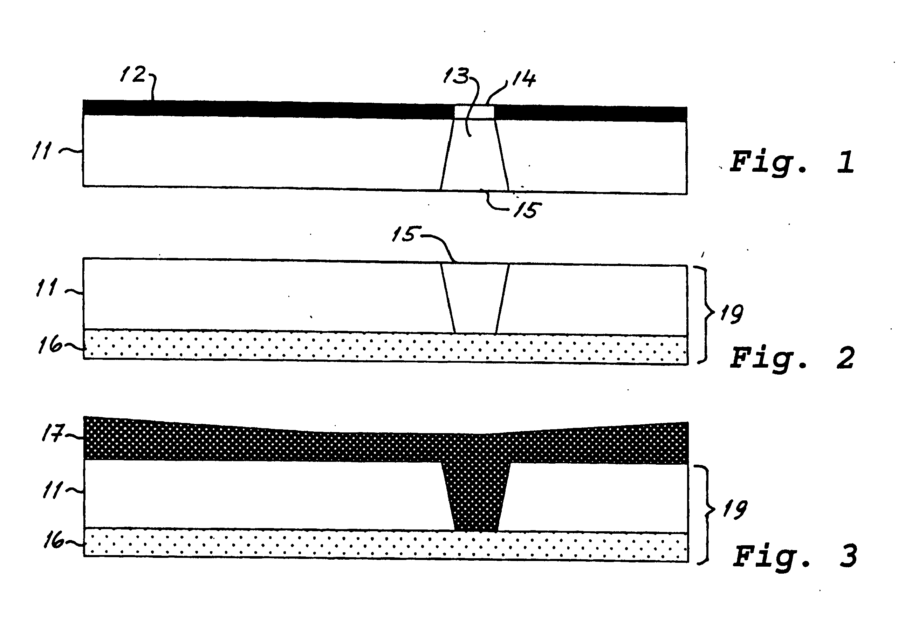

Anhand der Figuren 1 bis 4 wird nachstehend ein Verfahren zur Herstellung eines mikrostrukturierten Werkzeugeinsatzes zum Spritzgiessen eines Kunststoffsteils beschrieben, das eine Anordnung von Mikrostrukturen aufweist, die auf einer Aussenfläche des Kunststoffteils gebildet werden und eine vorbestimmte Tiefe haben. Dieses Verfahren ist auch zum Spritzgiessen eines Teils anwendbar, welches aus einem Metall oder aus einem keramischen Material hergestellt wird.

Wie in Fig. 1 gezeigt, wird in einem ersten Verfahrensschritt die Vorderseite eines Silizium-Wafers 11 photolithografisch mit einer Ätzmaskierung 12 maskiert, welche einer Anordnung von Mikrostrukturen entspricht.

Anschliessend wird der Wafer 11 mittels Trockenätzen in einem Plasma (Fachbegriff: DRIE= Deep Reactive Ion Etching) bestehend aus Ionen und reaktiven Fluor Radikalen mit einem sogenannten Throughetching durchgeätzt, wobei die Fluor Radikale das Silizium abtragen. Dazu wird das Ätzrezept so gewählt, dass der Hinterschnitt der gewünschten Entformungsschräge entspricht. Diese Forderung ist insofern erfüllbar, dass der Silizium Ätzprozess basierend auf dem Bosch Prozess zu Hinterschnitt neigt, insbesondere bei Ätzöffnungsbreiten > 20 Mikrometer. Dieser Effekt wird erfindungsgemäss ausgenutzt, um die gewünschte Entformungsschräge zu erzeugen.

Auf diese Weise wird im Silizium-Wafer 11 von der Vorderseite des Silizium-Wafers ausgehend eine Anordnung von Mikrostrukturen erzeugt, deren Tiefe sich über die ganze Dicke des ersten Wafers erstreckt, so dass die so erzeugten Mikrostrukturen Hohlräume 13 bilden, die auf der Vorderseite je eine Öffnung 14 und auf der Rückseite des ersten Wafers je eine Öffnung 15 haben. Der Silizium-Wafer 11 hat z.B. eine Dicke von 250 Mikrometer.

Anschliessend wird die Ätzmaskierung 12 von der Vorderseite des Silizium-Wafers 11 entfernt, der Wafer 11 gewendet und die Vorderseite des Silizium-Wafers 11, wie in Fig. 2 gezeigt, auf ein Trägersubstrat 16 gebondet, um die Eigenstabilität zu erhöhen und die Rückseite des Wafers 11 für das elektrochemische auftragen von Nickel zu versiegeln. Durch dieses Bonden vom Wafer 11 und Trägersubstrat 16 wird ein sogenannter Galvano-Master 19 gebildet.

In einer Variante des oben beschriebenen Verfahrens wird von der Vorderseite des Silizium-Wafers 11 ausgehend einer Anordnung von Mikrostrukturen erzeugt, welche Hohlräume bilden und deren Tiefe sich nur über einen Teil der Dicke des Wafers 11 erstreckt. In diesem Fall wird nach der Entfernung der Ätzmaskierung 12 und des Bonden der Vorderseite des Wafers 11 auf dem Trägersubstrat 16 eine Schicht des Wafers 11 abgetragen, um die nicht durchgeätzten Mikrostrukturen freizulegen und um die Tiefe der Mikrostrukturen einzustellen, welche dann sich über die ganze verbleibende Dicke des Wafers 11 erstrecken.

Als Trägersubstrat 16 eignen sich sowohl Pyrex-Wafer (Glas mit hohem Anteil an Natrium) als auch Silizium-Wafer.

Pyrex-Wafer werden mittels anodisch Bonding mit dem mikrostrukturierten Silizium-Wafer untrennbar verbunden.
Beim anodisch Bonding wird eine Hochspannung von z.B. 1000 V an die aufeinander gelegten Silizium und Pyrex-Wafer angelegt. Dabei diffundieren Natrium Ionen vom Pyrex in das Silizium und erzeugen eine hochfeste ionische Verbindung zwischen Pyrex und Silizium. Die Diffusion wird zusätzlich beschleunigt durch Erhöhung der Wafertemperatur auf z.B. 400°C).

Silizium-Wafer werden mittels Silicon Fusion Bonding mit dem mikrostrukturierten Silizium-Wafer untrennbar verbunden.
Beim Silizium Fusion Bonding werden die zu verbindenden Oberflachen von Silizium Substrat und mikrostrukturiertem Silizium-Wafer konditioniert und anschliessend unter Druck und Temperatur miteinander kovalent verbunden, vorausgesetzt die beiden zu verbindenden Oberflächen weisen sehr geringe Rauhigkeit auf(kleiner als 0.5 Nanometer), damit die beiden Oberflachen unmittelbar miteinander in Kontakt treten.

Als nächster Verfahrensschritt wird das mikrostrukturierte Silizium-Wafer 11 mit dem Trägersubstrat 16, zusammen Master 19 genannt, mit einer leitenden Dünnschicht versehen, die als Startschicht für die nachstehend beschriebene elektrochemische Abscheidung dient. Als solche eignen sich z.B. Gold, Silber und Nickel die physikalisch mittels dem Sputter- (auch bekannt unter dem Begriff Kathodenzerstäubung) oder Aufdampfverfahren nach Beschichtung mit einer Haftschicht aus Aluminium, Titan oder Chrom aufgebracht werden.

Anschliessend wird, wie in Fig. 3. gezeigt, der Master 19 via die leitende Startschicht elektrisch kontaktiert und elektrochemisch eine dicke Metallschicht 17, vorzugsweise eine Nickelschicht abgeschieden, um eine mechanisch stabile Backplatte mit einer Dicke von z.B. 1 Millimeter zu bilden.

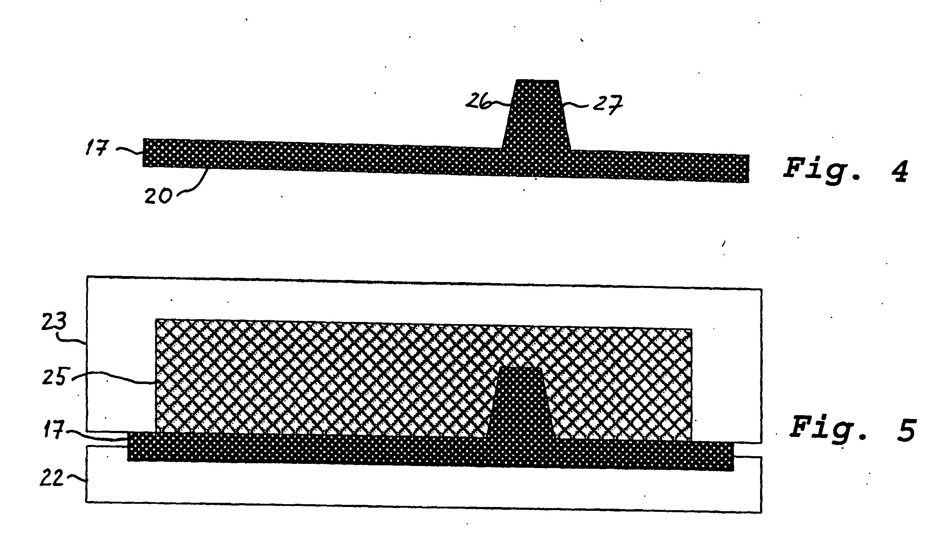

Nach der oben erwähnten Abscheidung von z.B. einer Nickelschicht 17, auch Nickel Schim genannt, wird zuerst die Ruckseite 20 des Nickel Shims planarisiert. Dazu eignet sich erodieren und schleifen. Anschliessend muss der mikrostrukturierte Nickel Werkzeugeinsatz 17 (nachfolgend Shim genannt) vom Master 19 getrennt werden. Dazu wird der Master 19 entweder mechanisch vom Shim 17 getrennt oder in einer geeigneten Nassätzchemie oder durch Trockenätzen aufgelost. Fig. 4 zeigt der getrennte Nickel Shim 17 mit planarisierter Rückseite 20.

Die abgetrennten Metallschicht 17 ist als formgebende Teil eines erfindungsgemäss hergestellten Werkzeugeinsatzes verwendbar, und hat seitliche Aussenflächen 26, 27 welche die Bildung von Entformungsschrägen ermöglichen, die z.B. grösser als 2 Grad sind.

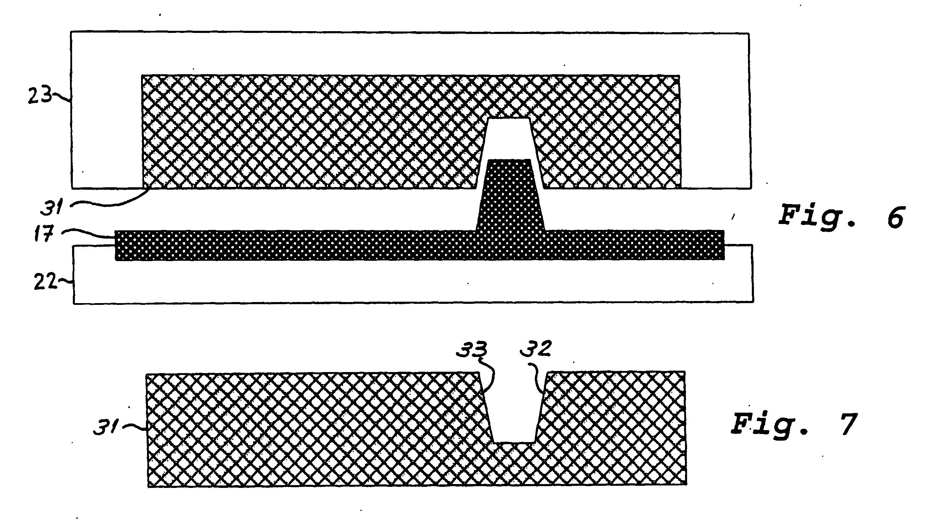

Ein Verfahren zum Spritzgiessen eines Kunststoffsteils wird nachstehend anhand der Figuren 5 bis 7 beschrieben.

Zum Spritzgiessen eines Kunststoffsteils wird der Nickel Shim 17 in einer Werkzeughälfte 22 eingebaut, die gegenüber einer zweiten Werkzeughälfte 23 des Spritzgusswerkzeuges angeordnet ist. Das Spritzgusswerkzeug wird geschlossen und eine Kunststoffschmelze 25 in den Innenraum des Spritzgusswerkzeuges eingespritzt.

Nach dem Erstarren der Kunststoffschmelze 25 und Öffnen des Spritzgusswerkzeuges lässt sich das Kunststoffteil 31 mit wenig Kraftaufwendung vom Shim entformen. Vorteilhaft ist es, dass dabei keine Beeinträchtigung der Qualität der Mikrostrukturen vorkommt und dass auch wenn der Wafer viele Mikrostrukturen aufweist nur geringe Entformungskräfte erforderlich sind um das Kunststoffteil zu entformen. Ein weiterer Vorteil des oben beschriebenen Verfahrens ist, dass sich dadurch Mikrostrukturen mit sehr guter Tiefenuniformität herstellen lassen.

Das Kunststoffteil 31 hat Mikrostrukturen mit seitlichen Innenflächen 32, 33 die Entformungsschrägen aufweisen, welche z.B. grösser als 2 Grad sind.

## Patentansprüche

1. Verfahren zur Herstellung eines Werkzeugeinsatzes (17) zum Spritzgiessen eines mikrostrukturierten Teils (31), welches aus einem Kunststoff, einem Metall oder aus einem keramischen Material hergestellt wird und welches eine Anordnung von Mikrostrukturen aufweist, die auf einer Aussenfläche des Teils (31) gebildet werden und eine vorbestimmte Tiefe haben, welches Verfahren folgende Schritte umfasst
(a) photolithographisches Maskieren der Vorderseite eines ersten Wafers (11) mit einer ersten Ätzmaskierung (12), welche einer Anordnung von Mikrostrukturen entspricht,
(b) Mikrostrukturieren des ersten Wafers (11) mittels Plasmaätzen der Vorderseite des ersten Wafers (11) zur Bildung einer Anordnung von Mikrostrukturen, welche Hohlräume (13) bilden und deren Tiefe sich über einen Teil der Dicke des ersten Wafers (11) erstreckt, wobei das Mikrostrukturieren der Vorderseite des ersten Wafers (11) mit Hinterschnitt durchgeführt wird, so dass die gebildeten Mikrostrukturen einen Querschnitt haben, dessen Breite mit dem Abstand zur Vorderseite des ersten Wafers (11) zunimmt, so dass die Mikrostrukturen die Herstellung eines mikrostrukturierten Werkzeugeinsatzes (17) ermöglichen, welcher das Spritzgiessen von Teilen (31) mit Mikrostrukturen ermöglicht, welche Entformungsschrägen (32, 33) grösser als 2 Grad aufweisen,
(c) Entfernen der ersten Ätzmaskierung(12) von der Vorderseite des ersten Wafers (11),
(d) Bonden der Vorderseite des ersten Wafers (11) auf ein Trägersubstrat (16) zur Bildung eines Masters (19),
(e) Abtragen einer Schicht des ersten Wafers (11) zum freilegen der nicht durchgeätzten Mikrostrukturen und zum Einstellen der Tiefe der Mikrostrukturen
(f) Aufbringen einer elektrisch leitenden Dünnschicht auf der Rückseite des ersten Wafers (11) und auf den durch die erwähnten Hohlräume (13) zugänglichen Flächen des Trägersubstrats,
(g) elektrochemisches Abscheiden einer Metallschicht (17) auf der Rückseite des ersten Wafers (11) und in den darin vorhandenen durch die Mikrostrukturen gebildeten Hohlräume (13),
(h) Planarisieren der Aussenfläche (20) der abgeschiedene Metallschicht (17), und
(i) Trennen der Metallschicht (17) vom Master (19), wobei die abgetrennte Metallschicht (17) als Werkzeugeinsatz (17) zum Spritzgiessen eines Teils (31) verwendbar ist.

2. Verfahren zur Herstellung eines Werkzeugeinsatzes (17) zum Spritzgiessen eines mikrostrukturierten Teils (31), welches aus einem Kunststoff, einem Metall oder aus einem keramischen Material hergestellt wird und welches eine Anordnung von Mikrostrukturen aufweist, die auf einer Aussenfläche des Teils (31) gebildet werden und eine vorbestimmte Tiefe haben, welches Verfahren folgende Schritte umfasst
(a) photolithographisches Maskieren der Vorderseite eines ersten Wafers (11) mit einer ersten Ätzmaskierung (12), welche einer Anordnung von Mikrostrukturen entspricht,
(b) Mikrostrukturieren des ersten Wafers (11) mittels Plasmaätzen der Vorderseite des ersten Wafers (11) zur Bildung einer Anordnung von Mikrostrukturen, deren Tiefe sich über die ganze Dicke des ersten Wafers (11) erstreckt, so dass die Mikrostrukturen Hohlräume (13) bilden, die auf der Vorderseite und auf der Rückseite des ersten Wafers (11) je eine Öffnung(14, 15) haben, wobei das Mikrostrukturieren der Vorderseite des ersten Wafers (11) mittels Throughetching des ersten Wafers (11) mit Hinterschnitt durchgeführt wird, so dass die gebildeten Mikrostrukturen einen Querschnitt haben, dessen Breite mit dem Abstand zur Vorderseite des ersten Wafers (11) zunimmt, so dass die Mikrostrukturen die Herstellung eines mikrostrukturierten Werkzeugeinsatzes (17) ermöglichen, welcher das Spritzgiessen von Teilen (31) mit Mikrostrukturen ermöglicht, welche Entformungsschrägen (32, 33) grösser als 2 Grad aufweisen,
(c) Entfernen der ersten Ätzmaskierung(12) von der Vorderseite des ersten Wafers (11),
(d) Bonden der Vorderseite des ersten Wafers (11) auf ein Trägersubstrat (16) zur Bildung eines Masters (19),
(e) Aufbringen einer elektrisch leitenden Dünnschicht auf der Rückseite des ersten Wafers (11) und auf den durch die erwähnten Hohlräume (13) zugänglichen Flächen des Trägersubstrats (16),
(f) elektrochemisches Abscheiden einer Metallschicht (17) auf der Rückseite des ersten Wafers (11) und in den darin vorhandenen durch die Mikrostrukturen gebildeten Hohlräume (13),
(g) Planarisieren der Aussenfläche (20) der abgeschiedene Metallschicht (17), und
(h) Trennen der Metallschicht (17) vom Master (19), wobei die abgetrennte Metallschicht (17) als Werkzeugeinsatz (17) zum Spritzgiessen eines Teils (31) verwendbar ist.

3. Verfahren gemäss Anspruch 1 oder 2, **dadurch gekennzeichnet, dass** der erste Wafer (11) ein Silizium-Wafer ist.

4. Verfahren gemäss Anspruch 1 oder 2, **dadurch gekennzeichnet, dass** das Trägersubstrat (16) ein Pyrex-Wafer ist.

5. Verfahren gemäss Anspruch 1 oder 2, **dadurch gekennzeichnet, dass** das Trägersubstrat (16) ein Silizium-Wafer ist.

6. Verfahren gemäss Anspruch 1 oder 2, **dadurch gekennzeichnet, dass** die abgeschiedene Metallschicht (17) eine Nickelschicht ist.

7. Verfahren zum Spritzgiessen eines Teils(31), welches aus einem Kunststoff, einem Metall oder aus einem keramischen Material hergestellt wird und welches eine Anordnung von Mikrostrukturen aufweist, die auf einer Aussenfläche des Teils (31) gebildet werden und eine vorbestimmte Tiefe haben, wobei ein Werkzeug zum Spritzgiessen verwendet wird, das von einer ersten und einer zweiten Werkzeughälfte(22, 23) gebildet wird, welches Verfahren folgende Schritte umfasst
(a) Herstellung eines ersten Werkzeugeinsatzes (17) nach einem der Verfahren gemäss einem der Ansprüche 1, 3 bis 6 oder 2 bis 6,
(b) Einbauen des ersten Werkzeugeinsatzes (17), welcher zur Formung der Anordnung von Mikrostrukturen dient, in eine erste Werkzeughälfte (22),
(c) Schliessen der von den ersten und zweiten Werkzeugshälften (22, 23) gebildeten Werkzeugs zum Spritzgiessen,
(d) Einspritzen einer Materialschmelze (25) in den Raum zwischen den ersten und den zweiten Werkzeugshälften (22, 23),
(f) Abkühlen der eingespritzten Materialschmelze (25), und
(g) Ausstossen aus dem Werkzeug zum Spritzgiessen von einem Teil (31), das durch Erstarrung der eingespritzten Materialschmelze (25) gebildet wird und das Mikrostrukturen mit Entformungsschrägen (32, 33) aufweist.

## Claims

1. Method of producing a mould insert (17) for injection moulding a micro-structured part (31), made from a synthetic material, a metal or a ceramic material and which has a pattern of micro-structures which are formed in an external surface of the part (31) and have a predefined depth, which method comprises the following steps:
(a) photo-lithographically masking the front face of a first wafer (11) with a first etching mask (12) corresponding to a pattern of micro-structures,
(b) imparting micro-structures to the first wafer (11) by plasma etching the front face of the first wafer (11) in order to form a pattern of micro-structures which form cavities (13), the depth of which extends through a part of the thickness of the first wafer (11), and the process of imparting micro-structures to the front face of the first wafer (11) is performed with undercutting so that the cross-section of the resultant micro-structures has a width which increases the closer it is to the front face of the first wafer (11) so that the micro-structures enable a micro-structured mould insert (17) to be produced, permitting injection moulding of parts (31) with micro-structures which have oblique surfaces (32, 33) greater than 2 degrees to enable demoulding,
(c) removing the first etching mask (12) from the front face of the first wafer (11),
(d) bonding the front face of the first wafer (11) to a support substrate (16) in order to form a master (19),
(e) removing a layer of the first wafer (11) in order to expose the micro-structures that are not through-etched and adjust the depth of the micro-structures,
(f) applying an electrically conductive thin layer to the rear face of the first wafer (11) and to the surfaces of the support substrate accessible through said cavities (13),
(g) electro-chemically depositing a metal layer (17) on the rear face of the first wafer (11) and on the cavities (13) created therein by the micro-structures,
(h) rendering the external surface (20) of the deposited metal layer (17) planar and
(i) separating the metal layer (17) from the master (19), which separated metal layer (17) can be used as a mould insert (17) for injection moulding a part (31).

2. Method of producing a mould insert (17) for injection moulding a micro-structured part (31) made from a synthetic material, a metal or a ceramic material and which has a pattern of micro-structures which are formed in an external surface of the part (31) and have a predefined depth, which method comprises the following steps:
(a) photo-lithographically masking the front face of a first wafer (11) with a first etching mask (12) corresponding to a pattern of micro-structures,
(b) imparting micro-structures to the first wafer (11) by plasma etching the front face of the first wafer (11) in order to form a pattern of micro-structures, the depth of which extends through the entire thickness of the first wafer (11) so that the micro-structures form cavities (13) which each have an opening (14, 15) at the front face and at the rear face of the first wafer (11), and the process of imparting micro-structures to the front face of the first wafer (11) is performed by through-etching the first wafer (11) with undercutting so that the cross-section of the resultant micro-structures has a width which increases the closer it is to the front face of the first wafer (11) so that the micro-structures enable a micro-structured mould insert (17) to be produced, permitting injection moulding of parts (31) with micro-structures which have oblique surfaces (32, 33) greater than 2 degrees to enable demoulding,
(c) removing the first etching mask (12) from the front face of the first wafer (11),
(d) bonding the front face of the first wafer (11) to a support substrate (16) in order to form a master (19),
(e) applying an electrically conductive thin layer to the rear face of the first wafer (11) and to the surfaces of the support substrate (16) accessible through said cavities (13),
(f) electro-chemically depositing a metal layer (17) on the rear face of the first wafer (11) and on the cavities (13) created therein by the micro-structures,
(g) rendering the external surface (20) of the deposited metal layer (17) planar and
(h) separating the metal layer (17) from the master (19), which separated metal layer (17) can be used as a mould insert (17) for injection moulding a part (31).

3. Method as claimed in claim 1 or 2, **characterised in that** the first wafer (11) is a silicon wafer.

4. Method as claimed in claim 1 or 2, **characterised in that** the support substrate (16) is a Pyrex wafer.

5. Method as claimed in claim 1 or 2, **characterised in that** the support substrate (16) is a silicon wafer.

6. Method as claimed in claim 1 or 2, **characterised in that** the deposited metal layer (17) is a nickel layer.

7. Method of injection moulding a part (31) made from a synthetic material, a metal or a ceramic material and which has a pattern of micro-structures, which are formed on an external surface of the part (31) and have a predefined depth, a mould formed by a first and a second mould half (22, 23) being used for the injection moulding process, which method comprises the following steps:
(a) producing a first mould insert (17) using a method as claimed in one of claims 1, 3 to 6 or 2 to 6,
(b) fitting the first mould insert (17) used to form the pattern of micro-structures in a first mould half (22),
(c) closing the mould comprising the first and second mould halves (22, 23) in order to run the injection moulding process,
(d) injecting a material melt (25) into the space between the first and the second mould halves (22, 23),
(f) cooling the injected material melt (25) and
(g) ejecting from the injection-moulding mould a part (31) which is formed by solidifying the injected material melt (25) and incorporates the micro-structures with oblique surfaces (32, 33) for demoulding purposes.

## Revendications

1. Procédé pour la fabrication d'un insert d'outil (17) pour le moulage par injection d'une pièce (31) microstructurée, qui est fabriquée à base d'un plastique, d'un métal ou à base d'un matériau céramique et qui présente un agencement de microstructures, qui sont formées sur une surface extérieure de la pièce (31), et ont une profondeur prédéfinie, lequel procédé présente les étapes suivantes :
(a) masquage photolithographique du côté avant d'une première tranche (11) avec un premier masquage de décapage (12), qui correspond à un agencement de microstructures,
(b) microstructuration de la première tranche (11) au moyen de décapage au plasma du côté avant de la première tranche (11) pour la formation d'un agencement de micro-structures, qui forment des cavités (13) et dont la profondeur s'étend sur une partie de l'épaisseur de la première tranche (11), la microstructuration du côté avant de la première tranche (11) étant effectuée avec une contre-dépouille, de sorte que les microstructures formées ont une section dont la largeur augmente avec la distance au côté avant de la première tranche (11), de sorte que les microstructures permettent la fabrication d'un insert d'outil (17) micro-structuré, lequel permet le moulage par injection de pièces (31) avec des micro-structures qui présentent des chanfreins de démoulage (32, 33) supérieurs à 2 degrés,
(c) enlèvement du premier masquage de décapage (12) du côté avant de la première tranche (11),
(d) collage du côté avant de la première tranche (11) sur un substrat porteur (16) pour la formation d'un maître (19),
(e) enlèvement d'une couche de la première tranche (11) pour la mise à nu des micro-structures non décapées et pour le réglage de la profondeur des microstructures,
(f) application d'une couche mince éléctronductrice sur le côté arrière de la première tranche (11) et sur les surfaces, accessibles par les cavités (13) mentionnées, du substrat porteur,
(g) dépôt électrochimique d'une couche de métal (17) sur le côté arrière de la première tranche (11) et dans les cavités (13) présentes à l'intérieur et formées par les microstructures,
(h) aplanissement de la surface extérieure (20) de la couche de métal (17) déposée, et
(i) séparation de la couche métallique (17) du maître (19), la couche métallique (17) séparée pouvant être utilisée comme insert d'outil (17) pour le moulage par injection d'une pièce (31).

2. Procédé pour la fabrication d'un insert d'outil (17) pour le moulage par injection d'une pièce (31) microstructurée, qui est fabriquée à base d'un plastique, d'un métal ou d'un matériau céramique et qui présente un agencement de microstructures qui sont formées sur une surface extérieure de la pièce (31) et ont une profondeur prédéfinie, lequel procédé comprend les étapes suivantes
(a) masquage photolithographique du côté avant d'une première tranche (11) avec un premier décapage au plasma (12), qui correspond à un agencement de microstructures,
(b) microstructuration de la première tranche (11) au moyen de décapage au plasma du côté avant de la première tranche (11) pour la formation d'un agencement de microstructures, dont la profondeur s'étend sur toute l'épaisseur de la,première tranche (11), de sorte que les microstructures forment des cavités (13) qui ont chacune une ouverture (14, 15) sur le côté avant et sur le côté arrière de la première tranche (11), la microstructuration du côté avant de la première tranche (11) étant effectuée par "throughetching" de la première tranche (11) avec contre-dépouille, de sorte que les microstructures formées ont une section dont la largeur augmente avec la distance au côté avant de la première tranche (11), de sorte que les microstructures permettent la fabrication d'un insert d'outil (17) micro-structuré, lequel permet le moulage par injection de pièces (31) avec des micro-structures, qui présentent des chanfreins de démoulage (32, 33) supérieurs à 2 degrés,
(c) enlèvement du premier masquage de décapage (12) du côté avant de la première tranche (11),
(d) collage du côté avant de la première tranche (11) sur un substrat porteur (16) pour la formation d'un maître (19),
(e) application d'une couche mince électro-conductrice sur le côté avant de la première tranche (11) et sur les surfaces, accessibles par les cavités (13) mentionnées, du substrat porteur (16),
(f) dépôt électrochimique d'une couche de métal (17) sur le côté arrière de la première tranche (11) et dans les cavités (13) présentes à l'intérieur et formées par les microstructures,
(g) aplanissement de la surface extérieure (20) de la couche de métal (17) déposée, et
(h) séparation de la couche de métal (17) du maître (19), la couche de métal (17) déposée pouvant être utilisée comme insert d'outil (17) pour le moulage par injection d'une pièce (31).

3. Procédé selon la revendication 1 ou 2, **caractérisé en ce que** la première tranche (11) est une tranche de silicium.

4. Procédé selon la revendication 1 ou 2, **caractérisé en ce que** le substrat porteur (16) est une tranche de Pyrex.

5. Procédé selon la revendication 1 ou 2, **caractérisé en ce que** le substrat porteur (16) est une tranche de silicium.

6. Procédé selon la revendication 1 ou 2, **caractérisé en ce que** la couche de métal (17) déposée est une couche de nickel.

7. Procédé pour le moulage par injection d'une pièce (31), qui est fabriquée à base d'un plastique, d'un métal ou d'un matériau céramique et qui présente un agencement de micro-structures, qui sont formées sur une surface extérieure de la pièce (31) et ont une profondeur prédéfinie, un outil étant utilisé pour le moulage par injection, qui est formé par une première et une seconde moitiés d'outil (22, 23), lequel procédé présente les étapes suivantes:
(a) fabrication d'un premier insert d'outil (17) selon l'un des procédés selon l'une quelconque des revendications 1, 3 à 6 ou 2 à 6,
(b) montage d'un premier insert d'outil (17), qui sert au formage de l'agencement de micro-structures, dans une première moitié d'outil (22),
(c) fermeture de l'outil formé par les première et seconde moitiés d'outil (22, 23) pour le moulage par injection,
(d) injection d'une masse fondue de matériau (25) dans l'espace entre les premières et les secondes moitiés d'outil (22, 23),
(f) refroidissement de la masse fondue de matériau (25) injectée, et
(g) expulsion de l'outil pour le moulage par injection d'une pièce (31), qui est formée par la solidification de la masse fondue de matériau (25) injectée et qui présente des microstructures avec des chanfreins de démoulage (32, 33).
